# EUROPEAN PATENT APPLICATION

(11) **EP 2 738 776 A1**
(43) Date of publication of application: **04.06.2014**
(21) Application number: 12834716.8
(22) Date of filing: 21.09.2012
(51) Int. Cl.: H01B 13/00, B32B 7/02, B32B 9/00, H01B 5/14

(54) **TRANSPARENT CONDUCTOR AND METHOD FOR PRODUCING SAME**

(30) Priority: 29.09.2011 JP 2011214679
(71) Applicant: Kyushu University, National University Corporation, Fukuoka-shi, Fukuoka 812-8581 (JP); Toray Industries, Inc., Tokyo 103-8666 (JP)
(72) Inventor: IMAZU, Naoki, Otsu-shi Shiga 5208558 (JP); WATANABE, Osamu, Otsu-shi Shiga 5208558 (JP); NAKASHIMA, Naotoshi, Fukuoka-shi Fukuoka 8128581 (JP); FUJIGAYA, Tsuyohiko, Fukuoka-shi Fukuoka 8128581 (JP)
(74) Representative: Hoefer & Partner
(86) International application number: PCT/JP2012/074155
(87) International publication number: WO 2013/047341

(57) **Abstract**

A method for producing a transparent conductor wherein an electrically conductive laminate structure is formed on at least one surface of the transparent substrate by spreading a dispersion containing carbon nanotubes on a transparent substrate and drying the dispersion to form an electrically conductive layer, is provided. This method includes the step of forming an undercoat layer containing a hole doping compound at a proportion of 0.2 to 20% by weight on the transparent substrate before forming the electrically conductive layer, or the step of forming an overcoat layer containing a hole doping compound at a proportion of 0.2 to 20% by weight after forming the electrically conductive layer. Also provided is a transparent conductor having an undercoat layer containing a hole doping compound at a proportion of 0.2 to 20% by weight and an electrically conductive layer containing carbon nanotubes in this order, or an electrically conductive layer containing carbon nanotubes and an overcoat layer containing a hole doping compound at a proportion of 0.2 to 20% by weight in this order, on at least one surface of the transparent substrate. A simple and productive method capable of forming a carbon nanotube transparent conductor having excellent transparent electrical conductivity is provided.

## Description

### [Technical Field]

This invention relates to a transparent conductor and a method for producing a transparent conductor. More specifically, this invention relates to a transparent conductor having a high electrical conductivity and a simple method for producing such transparent conductor. The transparent conductor of the present invention is mainly used as a material for an electrode in devices requiring surface smoothness, for example, touch screen, liquid crystal display, organic electroluminescence, and electronic paper.

### [Background Art]

Carbon nanotubes have morphology substantially comprising a sheet of graphite rolled into a cylinder. The one having single-rolled layer is called single-walled carbon nanotubes, and the one having a multiple-rolled layer is called multi-walled carbon nanotubes. Among these, the one having two layers is called double-walled carbon nanotubes. Carbon nanotubes have excellent intrinsic electrical conductivity by themselves, and their use for electrically conductive material is highly awaited.

Transparent conductors prepared by using carbon nanotubes are known in the art. Carbon nanotubes have been synthesized as a mixture of those having metallic nature and those having semiconductor nature. In order to obtain carbon nanotubes having a high electrical conductivity, separation of the carbon nanotubes obtained as a mixture of a metallic substance and a semiconductor substance is necessary. The separation technology, however, is associated with various technical difficulties, and such separation technology is currently unavailable. In the meanwhile, the carbon nanotubes can be readily used as an electroconductive material if the semiconductor carbon nanotubes can be converted to the metallic carbon nanotubes. In view of such situation, doping technology which improves electrical conductivity by chemically or electrochemically doping the carbon nanotubes have become a focus of attention.

The electrical conductivity of the carbon nanotube thin films can be improved by using a doped dispersant (see, for example, Patent Literature 1).

A method for improving the conductivity by using dipping or spin coating of the carbon nanotubes have also been reported (see, for example, Patent Literature 2).

A method for improving the electrical conductivity of the carbon nanotube electrode by forming metal nanoparticles on the surfaces of the carbon nanotube thin films by means of filtration has also been reported (see, for example, Patent Literature 3).

### [Prior Art Documents]

### [Patent Documents]

[Patent Document 1] Japanese Patent Application Laid-Open No. 2008-103329
[Patent Document 2] Japanese Patent Application Laid-Open No. 2008-297196
[Patent Document 3] Japanese Patent Application Laid-Open No. 2009-001481

### [Summary of Invention]

### [Problems to be Solved by the Invention]

Patent Literature 1 has the drawbacks of long time required for the doping treatment and necessity of the rinsing, and the technology's commercial feasibility is quite uncertain in view of the productivity. Putting Patent Literature 2 in practical use is also difficult in view of the productivity due to the coating conducted by dip coating or spin coating, and the necessity of rinsing. Commercialization of Patent Literature 3 is also difficult in view of the productivity due to the coating conducted by filtration and the necessity of rinsing.

The present invention has been completed in view of the situation as described above, and provision of a transparent conductor having a high electrical conductivity as well as a simple method for producing such transparent conductor is highly awaited.

### [Means for Solving Problems]

The inventors of the present invention made an intensive study, and found that, when an overcoat layer or an undercoat layer containing a doping agent is formed in contact with the electrically conductive layer containing the carbon nanotubes, a carbon nanotube transparent conductor can be produced by a simple and productive method without requiring a post-treatment such as rinsing. The present invention has been completed on the bases of such finding.

Accordingly, the method for producing the transparent conductor of the present invention is a method wherein an electrically conductive laminate structure is formed on at least one surface of the transparent substrate by spreading a dispersion containing carbon nanotubes on a transparent substrate and drying the dispersion to form an electrically conductive layer, wherein the method includes:
the step of forming an undercoat layer containing a hole doping compound at a proportion of 0.2 to 20% by weight on the transparent substrate before forming the electrically conductive layer, and/or
the step of forming an overcoat layer containing a hole doping compound at a proportion of 0.2 to 20% by weight after forming the electrically conductive layer.

The method for producing the transparent conductor of the present invention may also be a method comprising the steps of
forming an undercoat layer on a transparent substrate,
spreading a dispersion containing carbon nanotubes and drying the coated layer to form an electrically conductive layer, and
forming an overcoat layer,
conducted in this order to thereby form an electrically conductive laminate structure on at least one surface of the transparent substrate, wherein a hole doping compound is incorporated at a proportion of 0.2 to 20% by weight in the undercoat layer and/or the overcoat layer.

In the method for producing the transparent conductor of the present invention, the hole doping compound is preferably a metal halide.

In the method for producing the transparent conductor of the present invention, the metal halide preferably contains tetrachloroauric acid.

The undercoat layer formed in the method for producing the transparent conductor of the present invention preferably has a water contact angle of 5 to 20°.

The transparent conductor may also be the one having an undercoat layer containing a hole doping compound at a proportion of 0.2 to 20% by weight and an electrically conductive layer containing carbon nanotubes disposed in this order on at least one surface of the transparent substrate.

The transparent conductor may also be the one having an electrically conductive layer containing carbon nanotubes, and an overcoat layer containing a hole doping compound at a proportion of 0.2 to 20% by weight disposed in this order on at least one surface of the transparent substrate.

The transparent conductor may also be the one having an undercoat layer containing a hole doping compound at a proportion of 0.2 to 20% by weight, an electrically conductive layer containing carbon nanotubes, and an overcoat layer containing a hole doping compound at a proportion of 0.2 to 20% by weight disposed in this order on at least one surface of the transparent substrate.

The hole doping compound is preferably a metal halide.

The metal halide preferably contains tetrachloroauric acid.

### [Advantageous Effects of Invention]

The present invention is capable of producing a transparent conductor which has a surface resistivity value after the formation of the electrically conductive layer and without the doping treatment which is 10 to 50% lower than the surface resistivity of the transparent conductor produced by the conventional method before the doping treatment.

### [Description of Preferred Embodiments]

The method for producing the transparent conductor of the present invention is applicable to the production method comprising the steps of forming an undercoat layer on a transparent substrate; spreading a dispersion containing carbon nanotubes and drying the layer to form an electrically conductive layer; and forming an overcoat layer; conducted in this order to thereby form an electrically conductive laminate structure on at least one surface of the transparent substrate. In the present invention, the undercoat layer is a layer in contact with the electrically conductive layer on the side of the transparent substrate, and the overcoat layer is a layer in contact with the electrically conductive layer on the side of the surface of the transparent conductor. In the present invention, the hole doping compound is incorporated in such undercoat layer and/or overcoat layer at a proportion of 0.2 to 20% by weight. By forming the overcoat layer and/or the undercoat layer containing the doping agent in contact with the electrically conductive layer containing the carbon nanotubes, the transparent conductor of the present invention exhibits a surface resistivity after the formation of the electrically conductive layer and without the doping treatment which is 10 to 50% lower than the surface resistivity of the transparent conductor produced by the conventional method before the doping treatment. Conceivably, the effect of improving the electrical conductivity of the transparent conductor has been realized by converting the carbon nanotubes with the semiconductor nature which is a cause of the decrease of the electrical conductivity to the carbon nanotubes with metallic nature by doping with the hole doping compound. The effect of improving the electrical conductivity will be insufficient when the hole doping compound incorporated in the undercoat layer and/or overcoat layer is less than 0.2% by weight, while the effect of improving the electrical conductivity will be saturated even if the hole doping compound is incorporated at an amount in excess of 20% by weight.

As will be described later in detail, the step of forming the undercoat layer can be accomplished by employing a dry or wet coating, and the undercoat layer is preferably formed to a thickness of 1 to 500 nm. In the step of forming the electrically conductive layer, a dispersion containing carbon nanotubes is spread on the undercoat layer, and the coated layer is dried to thereby form the electrically conductive layer. In order to disperse the carbon nanotubes in the dispersion solvent, a dispersant as described below is preferably incorporated in the dispersion containing the carbon nanotubes. The dispersion containing the carbon nanotubes is preferably spread on the undercoat layer to a dried carbon nanotube coat with a weight of 1 to 40 mg/m².

As will be described later in detail, the step of forming the overcoat layer can be accomplished by employing a dry or wet coating. The overcoat layer is formed on the carbon nanotube layer containing the carbon nanotubes at a proportion of 1 to 40 mg/m² and the carbon nanotube layer is preferably formed to a thickness of 1 to 500 nm.

### [Carbon nanotubes]

The carbon nanotubes are not particularly limited as long as the carbon nanotubes substantially has a morphology comprising a sheet of graphite rolled into a cylinder, and the carbon nanotubes may be either the one having single-rolled layer, namely, the single-walled carbon nanotubes, or the one having a multiple-rolled layer, namely, the multi-walled carbon nanotubes. More specifically, the carbon nanotubes preferably contain at least 50% of double-walled carbon nanotubes. These double-walled carbon nanotubes are carbon nanotubes comprising double-rolled graphite layer, and the expression "the carbon nanotubes contain at least 50% of double-walled carbon nanotubes" means that at least 50 carbon nanotubes in the total of 100 carbon nanotubes are double-walled carbon nanotubes. When at least 50 carbon nanotubes in the total of 100 carbon nanotubes are double-walled carbon nanotubes, the carbon nanotubes will exhibit very high electrical conductivity as well as very high dispersibility of the carbon nanotubes in the coating dispersion. More preferably, at least 75 carbon nanotubes, and most preferably at least 80 carbon nanotubes in the total of 100 carbon nanotubes are double-walled carbon nanotubes. The use of the double-walled carbon nanotubes are preferable also in view of the fact that the function such as electrical conductivity inherent to the carbon nanotubes is less likely to be damaged even if functional groups are formed on the surface such function by acid treatment or the like.

### [Method for forming carbon nanotube electrically conductive layer]

The carbon nanotube electrically conductive layer is not particularly limited as long as it contains the carbon nanotubes. Exemplary methods used for the formation of the untreated electrically conductive layer include the spreading of the carbon nanotube dispersion on the substrate, direct deposition of the carbon nanotubes on the substrate, and transfer of the carbon nanotube film onto the substrate. Among these, the preferred is the spreading of the carbon nanotube dispersion on the transparent substrate in view of the ease of preparing the dispersion by using a dispersant and the dispersion solvent.

### [Carbon nanotube dispersant]

A dispersant is preferably used in dispersing the carbon nanotubes in the solvent. The dispersant is not particularly limited for its type whether the dispersant is a low molecular weight dispersant or a high molecular weight dispersant, or an ionic dispersant or a nonionic dispersant as long as the carbon nanotubes can be dispersed and the dispersibility required in the present invention is realized. The dispersant, however, is preferably a high molecular weight dispersant in view of the dispersibility and dispersion stability. Among these, the preferred are a polymer having polysaccharide or aromatic structure in the skeleton or a low molecular weight anionic surfactant in view of the excellent dispersibility. The polymer having a polysaccharide structure in its skeleton is hereinafter referred to as polysaccharide polymer, and the polymer having an aromatic structure in its skeleton is referred to as an aromatic polymer, and the low molecular weight anionic surfactant is referred to as an anionic surfactant. With regard to the homogeneous and isolated dispersion of the carbon nanotubes in the dispersion solvent by the dispersant as described above, the homogeneous dispersion of the carbon nanotubes in the solvent in isolated manner is extremely difficult since carbon nanotubes form strong bundles and aggregates are formed by entanglement of the bundles, and conceivably, isolated dispersion of the carbon nanotubes in the solvent should require loosening of the bundles and the aggregates through π electron interaction with the graphite of the carbon nanotubes or through hydrophobic interaction with the carbon nanotubes. It is estimated that the polysaccharide polymer or the aromatic polymer is effectively functioning in obtaining the carbon nanotube dispersion wherein the carbon nanotubes are more isolated.

Examples of the polysaccharide polymer suitable for the dispersant include carboxymethyl cellulose and its derivative, hydroxypropyl cellulose and its derivative, and xylan and its derivative, and the preferred is use of carboxymethyl cellulose or its derivative in view of the dispersibility, and the more preferred is the use of a salt of carboxymethyl cellulose or its derivative which is an ionic dispersant. When the salt of carboxymethylcellulose or its derivative as described above is used for the dispersant, the cationic substance constituting the salt may be a cation of an alkaline metal such as lithium, sodium, or potassium; a cation of an alkaline earth metal such as calcium, magnesium, or barium; ammonium ion or an onium ion of an organic amine such as monoethanolamine, diethanolamine, triethanolamine, morpholine, ethylamine, butylamine, coconut oil amine, beef tallow amine, ethylenediamine, hexamethylenediamine, diethylenetriamine, or polyethyleneimine; or a polyethylene oxide adduct thereof; while the cation is not limited to those as described above.

Examples of the aromatic polymer suitable for the dispersant include aromatic polyamide resins, aromatic vinyl resins, styrene resins, aromatic polyimide resins, polyaniline, and other electrically conductivity polymers, polystyrene sulfonic acid, poly-α-methylstyrene sulfonic acid, other polystyrenesulfonic acid derivatives. Among these, use of polystyrene sulfonic acid or its derivative is preferable in view of the dispersibility, and use of a salt of the polystyrene sulfonic acid or its derivative which is an ionic dispersant is more preferable.

Examples of the anionic surfactant suitable for the dispersant include octylbenzene sulfonate, nonylbenzene sulfonate, dodecylbenzene sulfonate, dodecyl diphenyl ether disulfonate salt, monoisopropyl naphthalene sulfonate salt, diisopropyl naphthalene sulfonate salt, triisopropyl naphthalene sulfonate salt, dibutyl naphthalene sulfonate salt, naphthalenesulfonic acid - formaldehyde condensate, sodium cholate, sodium deoxycholate, sodium glycocholate, and cetyltrimethylammonium bromide. Among these, the preferred is use of the sodium cholate or or dodecylbenzene sulfonate in view of the dispersibility.

Examples of the nonionic surfactant include sugar ester surfactants such as sorbitan fatty acid ester and polyoxyethylene sorbitan fatty acid ester; fatty acid ester surfactants such as polyoxyethylene resin acid ester and diethyl polyoxyethylene fatty acid ester; ether surfactants such as polyoxyethylenealkylether, polyoxyethylenealkylphenylether, and polyoxyethylene - polypropylene glycol; and aromatic nonionic surfactants such as polyoxyalkylene octylphenylether, polyoxyalkylene nonylphenylether, polyoxyalkyldibutylphenylether, polyoxyalkylstyrylphenylether, polyoxyalkylbenzylphenylether, polyoxyalkylbisphenylether, and polyoxyalkylcumylphenylether. Among these, the preferred is use of an aromatic nonionic surfactant in view of the excellent dispersibility, dispersion stability, and increase in the concentration.

Of the dispersants as described above, for example, dispersion of the carbon nanotubes by a polymer containing carboxylic acid group, sulfonic acid group, or hydroxy group which is a hydrophilic group is preferable when the solvent used is water. The particularly preferred is the dispersion of the carbon nanotubes by carboxymethyl cellulose which is a polysaccharide polymer.

With regard to the homogeneous and isolated dispersion of the carbon nanotubes in the dispersion solvent, the homogeneous dispersion of the carbon nanotubes in the dispersion solvent in isolated manner is extremely difficult since carbon nanotubes form strong bundles and aggregates are formed by entanglement of the bundles, and conceivably, isolated dispersion of the carbon nanotubes in the dispersion solvent should require loosening of the bundles and the aggregates through π electron interaction with the graphite of the carbon nanotubes or through hydrophobic interaction with the carbon nanotubes. It is estimated that the polysaccharide polymer is effectively functioning in obtaining the carbon nanotube dispersion wherein the carbon nanotubes are more isolated.

When the salt of carboxymethyl cellulose derivative is used for the dispersant, the cationic substance constituting the salt may be a cation of an alkaline metal such as lithium, sodium, or potassium; a cation of an alkaline earth metal such as calcium, magnesium, or barium; ammonium ion or an onium ion of an organic amine such as monoethanolamine, diethanolamine, triethanolamine, morpholine, ethylamine, butylamine, coconut oil amine, beef tallow amine, ethylenediamine, hexamethylenediamine, diethylenetriamine, or polyethyleneimine; or a polyethylene oxide adduct thereof; while the cation is not limited to those as described above.

### [Weight average molecular weight of the carbon nanotube dispersant]

The dispersant may preferably have a weight average molecular weight of at least 100. When the weight average molecular weight is at least 100, interaction with the carbon nanotubes are enabled and dispersion of the carbon nanotubes is improved. While the dispersibility differs by the length of the carbon nanotubes, interaction between the dispersant and the carbon nanotubes is facilitated in the case of the dispersant having a higher weight average molecular weight, and the dispersibility is thereby improved. For example, in the case of a polymer, the polymer will be entangled with the carbon nanotubes when the polymer chain has longer length, and very stable dispersion is thereby enabled. However, excessively high weight average molecular weight results in the reduced dispersibility, and the weight average molecular weight is preferably up to 10,000,000, and more preferably up to up to 1,000,000. Most preferably, the weight average molecular weight is in the range of 10,000 to 500,000.

### [Dispersion solvent for the carbon nanotubes]

The dispersion solvent used may be a dispersion solvent of an aqueous system or non-aqueous system which is capable of dissolving the dispersant as described above. In view of the waste treatment, environmental impact, and prevention of disaster, water is the preferable dispersion solvent.

Exemplary non-aqueous solvents include hydrocarbons (toluene, xylene, etc.), chlorine-containing hydrocarbons (methylene chloride, chloroform, chlorobenzene, etc.), ethers (dioxane, tetrahydrofuran, methyl cellosolve, etc.), ether alcohols (ethoxy ethanol, methoxyethoxy ethanol, etc.), esters (methyl acetate, ethyl acetate, etc.), ketones (cyclohexanone, methyl ethyl ketone, etc.), alcohols (ethanol, isopropanol, phenol, etc.), lower carboxylic acids (acetic acid, etc.), amines (triethylamine, trimethanol amine, etc.), nitrogen-containing polar solvents (N,N-dimethylformamide, nitromethane, N-methylpyrrolidone, etc.), and sulfur compounds (dimethyl sulfoxide, etc.).

### [Carbon nanotube dispersion]

The method used for preparing the dispersion of the present invention is not particularly limited. Typical dispersion means used in the preparation is the mixing of the carbon nanotubes and the dispersant in a dispersion solvent by using a mixer/blender mill(for example, ball mill, beads mill, sand mill, roll mill, homogenizer, ultrasonic homogenizer, high pressure homogenizer, ultrasonic device, attritor, dissolver, and paint shaker) commonly used in preparing the coating solution. Of these, the preferred is use of the dispersion using an ultrasonic device in view of the higher carbon nanotube dispersion in the coating dispersion.

### [Transparent substrate]

The thus obtained coating dispersion is spread on the substrate, and dried to obtain an untreated electrically conductive layer. Typical materials used for the substrate include resins and glass. Exemplary resins include polyesters such as polyethylene terephthalate (PET) and polyethylene naphthalate (PEN), polycarbonate (PC), polymethyl methacrylate (PMMA), polyimide, polyphenylene sulfide, aramid, polypropylene, polyethylene, polylactic acid, polyvinyl chloride, polymethyl methacrylate, alicyclic acrylic resin, cycloolefin resin, and triacetyl cellulose, and exemplary glasses include conventional soda glass. These materials may be used in combination, and exemplary such composite substrates include a substrate comprising a combination of a resin and a glass and a substrate comprising two or more resins. Another example is a substrate comprising a resin film provided with a hard coat. The type of the substrate is not limited to those as described above, and any suitable substrate may be selected depending on the application by considering durability, cost, and the like. While the transparent substrate is not particularly limited for its thickness, the thickness is preferably in the range of 10 µm to 1000 µm when used for the electrode used in touch screen, liquid crystal display, organic electroluminescence, and electronic paper and other display divides.

### [Spreading of the carbon nanotube dispersion on the substrate]

In the step of forming the carbon nanotube electrically conductive layer, the coating dispersion produced by the method as described above is spread on the substrate, and then, the dispersion solvent is dried to immobilize the carbon nanotubes on the substrate and form the untreated electrically conductive layer.

The method used for spreading the carbon nanotube dispersion on the substrate is not particularly limited, and any known method, for example, spray coating, dip coating, spin coating, knife coating, kiss coating, gravure coating, slot die coating, screen printing, ink jet printing, pad printing, other type of printing, or roll coating may be used. The coating may be conducted in two or more divided steps or by combining two different coating methods. The most preferable coating method is roll coating.

### [Adjustment of the coating thickness of the carbon nanotube layer]

Coating thickness (wet coating thickness) in the spreading of the coating dispersion on the substrate also depends on the concentration of the coating dispersion, and therefore, necessary adjustment may be made by considering the coating weight of the carbon nanotubes required for realizing the desired surface resistivity. The coating weight of the carbon nanotubes can be adequately adjusted to thereby realize use of the transparent conductor for various applications requiring the electrical conductivity. For example, when the coating weight of the carbon nanotubes is in the range of 1 mg/m² to 40 mg/m², the surface resistivity can be adjusted to the range of 1 x 10⁰ to 1 x 10⁴ Ω/□ When the coating weight is up to 40 mg/m², the surface resistivity can be adjusted to up to 1 x 10¹ Ω/□, and when the coating weight is up to 30 mg/m², the surface resistivity can be adjusted to 1 x 10² Ω/□. Furthermore, when the coating weight is up to 20 mg/m², the surface resistivity can be adjusted to up to 1 x 10³ Ω/□, and when the coating weight is up to 10 mg/m², the surface resistivity can be adjusted to up to 1 x 10⁴ Ω/□.

### [Wetting agent for carbon nanotube dispersant]

In the spreading of the carbon nanotube dispersion on the substrate, a wetting agent may be added to the coating dispersion to thereby reduce inconsistency of the coating. Since water is selected for the dispersion solvent of the carbon nanotube dispersion in the production of the transparent conductor, addition of a wetting agent such as a surfactant or an alcohol in the carbon nanotube dispersion prevents repelling of the coating dispersion by the substrate and spreading of the coating dispersion is thereby accomplished even when the coating dispersion is spread on a substrate having a non-hydrophilic surface. The wetting agent used is preferably an alcohol, and of the alcohols, the preferred are methanol, ethanol, propanol, and isopropanol, since lower alcohols such as methanol, ethanol, and isopropanol are highly volatile and easily removable by drying the substrate. Use of a mixture of an alcohol and water may be adequate in some cases.

### [Hole doping compound]

Hole doping compound is a compound which dopes hole to the carbon nanotubes (namely, which withdraws electron from the carbon nanotubes) to thereby improve electrical conductivity of the carbon nanotubes.

The hole doping compound may be generally classified into 4 categories, namely, non-metal non-halides, non-metal halides, metal non-halides, and metal halides.

Examples of the non-metal non-halide include sulfuric acid, nitric acid, and nitromethane.

Examples of the non-metal halide include chlorosulfonic acid, tetrafluorotetracyanoquinodimethane (F4-TCNQ), and N-Phenyl-bis(trifluoromethanesulfonimide).

The type of metal contained in the metal non-halide and the metal halide is not particularly limited. The metal non-halide and the metal halide, however, preferably contains at least one metal component selected from the group consisting of silver, gold, copper, platinum, nickel, iridium, and palladium.

Examples of the metal non-halide include silver nitrate (AgNO₃) and nickel (I) nitrate (Ni(NO₃)₂.6H₂O).

Examples of the metal halide include gold chloride (AuCl₃), tetrachloroauric acid (HAuCl₄), Chloro(tri-tert-butylphosphine)gold(I) (C₄H₉)₃PAuCl, platinum chloride (PtCl₄), tetrachloroplatinic acid (H₂PtCl₄), hexachloroplatinic acid (H₂PtCl₆), cupric chloride (CuCl₂), palladium chloride (PdCl₂), iron (III) chloride (FeCl₃), iridium chloride (IrCl₃), and silver bis(trifluoromethanesulfonyl)imide (Ag-TFSI).

Of the 4 types as described above, the preferred are metal halides in view of the effect of improving the electrical conductivity, and the most preferred is tetrachloroauric acid in view of the effect.

### [Undercoat layer]

In the present invention, an undercoat layer is provided on the transparent substrate. The material used for the undercoat layer is preferably a material having a high hydrophilicity. More specifically, the material used for the undercoat layer is a material having a water contact angle in the range of of 5 to 20°, and preferably, an inorganic oxide which is more preferably titania, alumina, or silica. These substances are preferable since they have a hydrophilic group (-OH group) on the surface, and accordingly, high hydrophilicity. Furthermore, the undercoat layer is a composite material of silica fine particles and a polysilicate.

In order to improve the hydrophilicity of the undercoat layer, the hydrophilic functional group may be exposed by surface hydrophilization. Exemplary methods used for the surface hydrophilization include physical treatments such as corona discharge treatment, plasma treatment, and flame treatment and chemical treatments such as acid treatment and alkaline treatment. Of these, the preferred are corona treatment and plasma treatment. As a result of such treatment, the surface is provided with surface properties with the water contact angle within the range as described above.

### [Method used in forming the undercoat layer]

In the present invention, the method used for providing the undercoat layer on the transparent substrate is not particularly limited, and any known wet method may be used. Exemplary wet coating methods include spray coating, dip coating, spin coating, knife coating, kiss coating, gravure coating, slot die coating, roll coating, bar coating, screen printing, ink jet printing, pad printing, or other type of coating. The method used for providing the undercoat layer may also be a dry coating method, and exemplary dry coating methods include physical and chemical vapor phase epitaxy such as sputtering and vapor deposition. The coating may be conducted in two or more divided steps or by combining two different coating methods. The most preferable coating method is wet coating such as gravure coating or bar coating.

### [Hole doping compound incorporated in the undercoat layer]

The hole doping compound used in the case of incorporating the hole doping compound in the undercoat layer is not particularly limited as long as the compound is those as described above. Concentration of the hole doping compound incorporated in the undercoat layer is preferably in the range of 0.2 to 20% by weight, preferably 2 to 20% by weight, and more preferably 2 to 10% by weight in view of the doping effect.

The method used for the formation of the undercoat layer containing the hole doping compound is not particularly limited, and in the formation of the undercoat layer, wet coating method may be employed, and a hole doping compound may be added to the coating solution used.

### [Adjustment of the thickness of the undercoat layer]

The undercoat layer is not particularly limited for its thickness while a thickness allowing effective prevention of reflection by the optical interference is preferable in view of improving the light transmittance. The thickness is preferably in the range of 10 nm to 300 nm, and more preferably 50 nm to 200 nm.

### [Water contact angle of the undercoat layer]

The contact angle with water can be measured by using a commercially available contact angle goniometer. The contact angle may be conducted according to JIS R3257 (1999) in an atmosphere at room temperature of 25°C and a relative humidity of 50% by dripping 1 to 4 µL of water on the surface of the undercoat with a syringe and observing the droplet from the direction of cross section to determine the contact angle between the tangential line of the droplet edge and the film surface plane.

### [Overcoat layer]

In the present invention, a transparent coating layer may be formed on the upper surface of the carbon nanotube layer after forming the carbon nanotube layer. Formation of such overcoat layer is preferable in view of further improving the transparent electrical conductivity, stable heat resistance, and stable wet and heat resistance.

Both organic and inorganic materials may be used for the overcoat layer material, and the preferred is use of an inorganic material in view of stability of the resistivity. Exemplary inorganic materials include metal oxides such as silica, tin oxide, alumina, zirconia, and titania, and the preferred is silica in view of the stability of the resistivity.

### [Method used in forming the overcoat layer]

In the present invention, the method used for providing the overcoat layer on the carbon nanotube layer is not particularly limited, and any known wet method may be used. Exemplary wet coating methods include spray coating, dip coating, spin coating, knife coating, kiss coating, roll coating, gravure coating, slot die coating, bar coating, screen printing, ink jet printing, pad printing, or other type of coating. The method used for providing the overcoat layer may also be a dry coating method, and exemplary dry coating methods include physical and chemical vapor phase epitaxy such as sputtering and vapor deposition. The procedure of forming the overcoat layer on the carbon nanotube layer may be conducted in two or more divided steps or by combining two different methods. The most preferable coating method is wet coating such as gravure coating or bar coating.

A preferable method of silica layer formation using the wet coating is use of the organosilane compound. In an exemplary method, the wet coating is carried out by using a coating solution prepared by dissolving a silica sol which had been prepared by hydrolyzing a tetraalkoxysilane such as tetramethoxysilane, tetraethoxysilane, tetra-n-propoxysilane, tetra-i-propoxysilane, or tetra-n-butoxysilane in a solvent for the coating solution, and promoting the dehydrocondensation of silanol groups in the drying of the solvent to thereby form the silica thin film.

Thickness of the overcoat layer is controlled by adjusting concentration of the silica sol in the coating solution and coating thickness in the coating step. The thickness of the overcoat layer is preferably in the range of 5 nm to 200 nm

### [Hole doping compound in the overcoat layer]

The hole doping compound used in the case of incorporating the hole doping compound in the overcoat layer is not particularly limited as long as the compound is those as described above. Concentration of the hole doping compound incorporated in the overcoat layer is preferably in the range of 0.2 to 20% by weight, in view of the doping effect. The concentration is more preferably 2 to 10% by weight.

The method used for the formation of the overcoat layer containing the hole doping compound is not particularly limited, and in the formation of the overcoat layer, wet coating method may be employed, and a hole doping compound may be added to the coating solution used.

### [Transparent electrical conductivity]

The transparent electroconductive laminate having excellent transparent electrical conductivity can be obtained by the procedure as described above. The total light transmittance is preferably in the range of 80% to 93%, and more preferably 90% to 93%. The surface resistivity value is preferably in the range of 1 x 10⁰ to 1 x 10⁴ Ω/□, and more preferably, the surface resistivity value is in the range of 1 x 10⁰ to 1 x 10³ Ω/□. The surface resistivity value and the total light transmittance can be adjusted by the coating weight of the carbon nanotubes, and more specifically, both the surface resistivity value and the total light transmittance will be high at a lower coating weight of the carbon nanotubes, and both will be low at a higher coating weight. The transparent electrical conductivity is superior at a lower surface resistivity value and at a higher total light transmittance, and the transparency and the electrical conductivity are in a trade-off relation. Accordingly, in the comparison of the transparent electrical conductivity, one index should be fixed while the other index is compared.

In the present invention, ratio of the total light transmittance of the transparent electrically conductive laminate after the coating to the total light transmittance of the transparent electrically conductive laminate before the spreading of the carbon nanotubes, namely, the total light transmittance of the transparent electrically conductive laminate after the coating divided by the total light transmittance of the transparent electrically conductive laminate before the coating (hereinafter referred to as "total light transmittance of the carbon nanotube layer") is used for the index of the light transmittance. This is an index of the transparent electrical conductivity of solely the carbon nanotube layer.

### [Application]

The transparent conductor of the present invention is well adapted for use in the electrode of the device using a display, for example, touch screen, liquid crystal display, organic electroluminescence, and electronic paper.

### [Examples]

Next, the present invention is described in detail by referring to the following Examples which by no means limit the scope of the present invention. The measurement in the Examples was conducted by the procedure as described below. Unless otherwise noted, the number of samples was 2.

### (1) Surface resistivity

The resistivity was measured at room temperature by 4 probe method by firmly contacting the probe at the center of the sample (5 cm x 10 cm) of the transparent conductor on the side of the carbon nanotube layer. The device used was resistivity meter Model MCP-T360 manufactured by DIA Instruments Co., Ltd., and the probe used was 4 probe MCP-TPO3P manufactured by DIA Instruments Co., Ltd.

### (2) Total light transmittance

Total light transmittance was measured by using haze meter NDH2000 manufactured by Nippon Denshoku Industries Co., Ltd. according to JIS-K7361 (1997).

### (3) Water contact angle

1 to 4 µL of water was dropped on the surface of the film with a syringe in an atmosphere at room temperature (25°C) and a relative humidity of 50%, and the droplet was observed from the direction of the cross section to determine the contact angle between the tangential line of the droplet edge and the film surface plane by using a contact angle meter (contact angle meter, Model CA-X, manufactured by Kyowa Interface Science Co., Ltd.).

### [Example of forming the undercoat layer]

### (1) Formation of the undercoat layer not containing the hole doping compound

A coating solution for forming a silica film (Mega Aqua Hydrophilic DM Coat DM-30-26G-N1 manufactured by Ryowa Corporation) containing hydrophilic silica fine particles of about 30 nm and polysilicate was used for the coating solution for the undercoat layer.

The coating solution was spread with a wire bar #8 on a biaxially stretched polyethylene terephthalate film "Lumirror" U46 manufactured by Toray Industries, Inc. having a thickness of 188 µm, and the coating was dried in a dryer at 80°C for 1 minute to thereby form an undercoat layer comprising a binder of polysilicate and having 30 nm silica fine particles exposed on the surface.

### (2) Formation of the undercoat layer containing a hole doping compound

The procedure of the Preparation Example (1) was repeated except that 1% by weight aqueous solution of tetrachloroauric acid (prepared by dissolving gold chloride manufactured by Wako Pure Chemical Industries, Ltd. in pure water; this applies to the following description), 1% by weight aqueous solution of iron chloride (prepared by dissolving iron chloride manufactured by Wako Pure Chemical Industries, Ltd. in pure water; this applies to the following description), or 1% by weight solution of silver bis(trifluoromethanesulfonyl)imide (prepared by dissolving silver bis(trifluoromethanesulfonyl)imide manufactured by Sigma-Aldrich in isopropyl alcohol; this applies to the following description) was added to the coating solution for forming a silica film (Mega Aqua Hydrophilic DM Coat DM-30-26G-N1 manufactured by Ryowa Corporation) at 25°C so that content by weight of the hole doping compound in solid content was as shown in Table 1, and the thus prepared coating solution for forming the undercoat layer was used to thereby form an undercoat layer containing the hole doping compound.

### [Example of forming the corona-treated substrate]

"Lumirror" U46 manufactured by Toray Industries, Inc. was treated by moving the electrode of corona discharge surface modification test equipment (TEC-4AX, KASUGA DENKI, INC.) 5 times. The electrode was moved at a power of 100 W and a speed of 6.0 m/minute so that the distance between the electrode and the transparent substrate was 1 mm,. As a consequence, hydrophilicity of the substrate surface increased and the water contact angle decreased from 56° to 43°.

### [Example of preparing the catalyst for the carbon nanotubes]

About 24.6 g of ammonium iron (III) citrate (manufactured by Wako Pure Chemical Industries, Ltd.) was dissolved in 6.2 kg of ion exchanged water. About 1000 g of magnesium oxide (MJ-30 manufactured by Iwatani Chemical Industry Co., Ltd.) was added to this solution and vigorously agitated for 60 minutes with an agitator, and the suspension was introduced in a 10 L (liter) autoclave vessel. In this process, 0.5 kg of ion exchanged water was used for the washing. The suspension was heated to 160 °C and retained at this temperature for 6 hours in sealed condition. The autoclave vessel was allowed to cool, and whitish slurry was collected from the vessel. Excessive moisture was removed by filtration with suction, and the small amount moisture in the filter residue was dried in a drier at 120°C. From the resulting solid content, those having the particle size of 20 to 32 mesh were collected on the sieve while pulverizing in the mortar. The thus obtained granular catalyzer was placed in an electric furnace, and heated in the atmosphere at 600°C for 3 hours. The bulk density was 0.32 g /mL (milliliter). When the filtrate was analyzed by energy dispersive X-ray spectrometer (EDX), the iron was not detected, and this confirmed that the entire amount of the ammonium iron (III) citrate added had been loaded on the magnesium oxide. The result of the EDX analysis of the catalyzer revealed that the iron content in the catalyzer was 0.39% by weight.

### [Step of producing the carbon nanotube-containing composition]

132 g of the solid catalyzer prepared according to the Example of preparing the catalyst was introduced on the sintered quartz plate at the center part of the reactor installed in vertical direction. While the catalyzer layer was heated until the temperature in the reactor tube reached about 860°C, nitrogen gas was supplied at 16.5 L (liter)/minute by using a mass flow controller from the bottom of the reactor in the direction toward the upper part of the reactor so that the nitrogen gas passed through the catalyzer layer, and then, with the nitrogen gas still supplied, methane gas was supplied at 0.78 L (liter)/minute for 60 minutes by the mass flow controller so that the methane gas passed through the catalyzer layer. The reaction was thereby promoted. The contact time (W/F) determined by dividing the weight of the solid catalyzer by the flow rate of the methane was 169 minutes.g/L (liter), and the linear velocity of the methane-containing gas was 6.55 cm/second. Introduction of the methane gas was then stopped, and the quartz reaction tube was cooled to room temperature with the nitrogen gas passing at 16.5 L (liter)/minute.

The heating was ceased, and the temperature was allowed to cool to room temperature, and when the temperature was at room temperature, the carbon nanotube-containing composition containing the catalyzer and the carbon nanotubes (hereinafter referred to as the catalyst-containing carbon nanotube composition) were removed from the reactor.

115 g of this catalyst-containing carbon nanotube composition was stirred in 2000 ml (milliliter) of 4.8N aqueous solution of hydrochloric acid for 1 hour to dissolve the iron which is the catalyst metal and MgO which is the carrier. The resulting black suspension was filtered, and the filtration residue was again added to 400 ml (milliliter) of 4.8N aqueous solution of hydrochloric acid for the de-MgO treatment and collection of the filtration residue. This procedure was repeated three times to obtain the carbon nanotube composition (hereinafter referred to as de-catalyzed carbon nanotube composition) having the catalyst removed (which is hereinafter referred to as de-catalyzed carbon nanotube composition). This de-catalyzed carbon nanotube composition was added to about 300 parts by weight of concentrated nitric acid (first grade, for assay, 60 to 61% manufactured by Wako Pure Chemical Industries, Ltd.). The mixture was heated under reflux with stirring in an oil bath at about 140°C for 25 hours. The nitric acid solution containing the carbon nanotubes after heating under reflux was diluted three times with ion exchanged water, and filtered under suction. After washing the filter residue with ion exchanged water until neutrality, the carbon nanotubes were stored under the wet condition containing the water (this carbon nanotubes in wet condition is hereinafter simply referred to as the carbon nanotube composition). When this carbon nanotube composition was observed with a high resolution electron microscope, content of the bilayer carbon nanotubes in the total number of the carbon nanotubes contained in the carbon nanotube composition was 90%.

### [Preparation of carbon nanotube dispersion 1]

25 mg of carbon nanotubes (the carbon nanotube composition containing 25 mg of carbon nanotubes in terms of dry weight), 7.5 g of 1% by weight aqueous solution of sodium carboxymethyl cellose (Cellogen 5A (weight average molecular weight, 80,000) manufactured by Dai-Ichi Kogyo Seiyaku Co. Ltd.), and 6.7 g of zirconia beads ("Torayceram" having a beads size of 0.8 mm manufactured by Toray) were placed in a vessel, and pH was adjusted to 10 with 28% by weight ammonia solution (manufactured by Kishida Chemical Co., Ltd.). Weight ratio of the dispersant to the carbon nanotubes in this dispersion was 3. The container was oscillated for 2 hours by using a vibration mill to prepare a carbon nanotube paste.

Next, this carbon nanotube paste was diluted with ion exchanged water to a carbon nanotube concentration of 0.15% by weight, and 10 g of the diluted solution was again adjusted to pH 10 with 28% by weight ammonia solution. The aqueous solution was dispersed in an ultrasonic homogenizer in an ice bath at a power of 20 W for 1.5 minutes. During the dispersion, the solution was kept at a temperature of up to 10°C. The resulting solution was subjected to centrifugation at 10000 G for 15 minutes in a high speed centrifuge to obtain 9 g of carbon nanotube dispersion.

### [Preparation of carbon nanotube dispersion 2]

25 mg of carbon nanotubes (the carbon nanotube composition containing 25 mg of carbon nanotubes in terms of dry weight), 7.5 g of 1% by weight aqueous solution of sodium carboxymethyl cellose (Cellogen 7A (weight average molecular weight, 190,000) manufactured by Dai-Ichi Kogyo Seiyaku Co. Ltd.), and 6.7 g of zirconia beads ("Torayceram" having a beads size of 0.8 mm manufactured by Toray) were placed in a vessel, and pH was adjusted to 10 with 28% by weight ammonia solution (manufactured by Kishida Chemical Co., Ltd.). Weight ratio of the dispersant to the carbon nanotubes in this dispersion was 3. The container was oscillated for 2 hours by using a vibration mill to prepare a carbon nanotube paste.

Next, this carbon nanotube paste was diluted with ion exchanged water to a carbon nanotube concentration of 0.15% by weight, and 10 g of the diluted solution was again adjusted to pH 10 with 28% by weight ammonia solution. The aqueous solution was dispersed in an ultrasonic homogenizer in an ice bath at a power of 20 W for 1.5 minutes. During the dispersion, the solution was kept at a temperature of up to 10°C. The resulting solution was subjected to centrifugation at 10000 G for 15 minutes in a high speed centrifuge to obtain 9 g of carbon nanotube dispersion.

### [Coating of the carbon nanotube dispersion]

The carbon nanotube dispersion was adjusted to 0.055% by weight (Examples 1 to 3, 10 to 12, and 19 and Comparative Examples 1, 3, and 4) or 0.04% by weight (Examples 4 to 9, 13 to 18, and 20 to 23 and Comparative Examples 2 and 5) by adding ion exchanged water, and the dispersion was spread on the substrate which had been formed with the undercoat layer by using a wire bar #4 (Examples 10 to 12, and Comparative Example 3) or #5 (Examples 1 to 9 and 13 to 24 and Comparative Examples 1, 2, 4, and 5). The carbon nanotube composition was immobilized by drying at 80°C for 1 minute in a dryer (the film having the carbon nanotube composition immobilized thereon is hereinafter referred to as the carbon nanotube coated film). The coating weight of the carbon nanotubes corresponding to each coating condition was as shown in Table 1.

### [Example of forming the overcoat layer]

### (1) Formation of the overcoat layer not containing the hole doping compound

20 g of ethanol was placed in a 100 ml plastic container, and 40 g of n-butyl silicate was added. After stirring the mixture for 30 minutes, 10 g of 0.1N aqueous solution of hydrochloric acid was added, and the mixture was stirred for 2 hours. The mixture was allowed to stand at 4°C for 12 hours, and this solution was diluted with a mixture of toluene, isopropyl alcohol, and methyl ethyl ketone to a solid concentration of 1% by weight. A coating solution for the formation of the overcoat layer was thereby prepared.

The coating solution for forming the overcoat layer was spread with a wire bar #8 on the carbon nanotube layer, and the coating was dried in a dryer at 125°C for 1 minute to thereby form an overcoat layer.

### (2) Formation of the overcoat layer containing a hole doping compound

The procedure of the Preparation Example (1) was repeated except that 1% by weight aqueous solution of tetrachloroauric acid (prepared by dissolving gold chloride manufactured by Wako Pure Chemical Industries, Ltd. in pure water; this applies to the following description), 1% by weight aqueous solution of iron chloride (prepared by dissolving iron chloride manufactured by Wako Pure Chemical Industries, Ltd. in pure water; this applies to the following description), or 1% by weight solution of silver bis(trifluoromethanesulfonyl)imide (prepared by dissolving silver bis(trifluoromethanesulfonyl)imide manufactured by Sigma-Aldrich) in isopropyl alcohol; this applies to the following description) was added at 25°C so that content by weight of the hole doping compound in solid content was as shown in Table 1, and the thus prepared coating solution for forming the overcoat layer was used to thereby form undercoat layer containing the hole doping compound.

### (Example 1)

An undercoat layer having a tetrachloroauric acid content of 20% by weight was formed by repeating the procedure of the Example of forming the undercoat layer. A carbon nanotube layer was formed on the undercoat layer by using the carbon nanotube dispersion 1, and an overcoat layer was formed on the carbon nanotube layer by using the procedure of the Example of forming the overcoat layer to thereby form a transparent conductor. The surface resistivity and the total light transmittance were then measured.

### (Examples 2 to 3 and Comparative Example 1)

The transparent conductor was prepared by repeating the procedure of Example 1 except that the combination of the formation of the undercoat layer, the carbon nanotube dispersion, and the formation of the overcoat layer was those shown in Table 1. The surface resistivity and the total light transmittance were then measured.

### (Example 4)

An undercoat layer having a tetrachloroauric acid content of 20% by weight was formed by repeating the procedure of the Example of forming the undercoat layer. A carbon nanotube layer was formed on the undercoat layer by using the carbon nanotube dispersion 2, and an overcoat layer was formed on the carbon nanotube layer by using the procedure of the Example of forming the overcoat layer to thereby form a transparent conductor. The surface r resistivity and the total light transmittance were then measured.

### (Examples 5 to 8 and Comparative Example 2)

The transparent conductor was prepared by repeating the procedure of Example 4 except that the combination of the formation of the undercoat layer, the carbon nanotube dispersion, and the formation of the overcoat layer was those shown in Table 1. The surface resistivity and the total light transmittance were then measured.

### (Example 9)

An undercoat layer having an iron chloride content of 20% by weight was formed by repeating the procedure of the Example of forming the undercoat layer. A carbon nanotube layer was formed on the undercoat layer by using the carbon nanotube dispersion 2, and an overcoat layer was formed on the carbon nanotube layer by using the procedure of the Example of forming the overcoat layer to thereby form a transparent conductor. The surface resistivity and the total light transmittance were then measured.

### (Example 10)

An undercoat layer was formed by repeating the procedure of forming the undercoat layer. A carbon nanotube layer was formed on the undercoat layer by using the carbon nanotube dispersion 1, and an overcoat layer having a tetrachloroauric acid content of 10% by weight was formed on the carbon nanotube layer by using the procedure of forming the overcoat layer to thereby form a transparent conductor. The surface resistivity and the total light transmittance were then measured.

### (Examples 11 and 12 and Comparative Example 3)

The transparent conductor was prepared by repeating the procedure of Example 10 except that the combination of the formation of the undercoat layer, the carbon nanotube dispersion, and the formation of the overcoat layer was those shown in Table 1. The surface resistivity and the total light transmittance were then measured.

### (Example 13)

An undercoat layer was formed by repeating the procedure of forming the undercoat layer. A carbon nanotube layer was formed on the undercoat layer by using the carbon nanotube dispersion 2, and an overcoat layer having a tetrachloroauric acid content of 20% by weight was formed on the carbon nanotube layer by using the procedure of forming the overcoat layer to thereby form a transparent conductor. The surface resistivity and the total light transmittance were then measured.

### (Examples 14 to 17)

The transparent conductor was prepared by repeating the procedure of Example 13 except that the combination of the formation of the undercoat layer, the carbon nanotube dispersion, and the formation of the overcoat layer was those shown in Table 1. The surface resistivity and the total light transmittance were then measured.

### (Example 18)

An undercoat layer was formed by repeating the procedure of forming the undercoat layer. A carbon nanotube layer was formed on the undercoat layer by using the carbon nanotube dispersion 2, and an overcoat layer having a silver bis(trifluoromethanesulfonyl)imide content of 10% by weight was formed on the carbon nanotube layer by using the procedure of forming the overcoat layer to thereby form a transparent conductor. The surface resistivity and the total light transmittance were then measured.

### (Example 19)

An undercoat layer having a tetrachloroauric acid content of 10% by weight was formed by repeating the procedure of the Example of forming the undercoat layer. A carbon nanotube layer was formed on the undercoat layer by using the carbon nanotube dispersion 1, and an overcoat layer having a tetrachloroauric acid content of 1% by weight was formed on the carbon nanotube layer by using the procedure of forming the overcoat layer to thereby form a transparent conductor. The surface resistivity and the total light transmittance were then measured.

### (Comparative Example 4)

An undercoat layer was formed by repeating the procedure of forming the undercoat layer. A carbon nanotube layer was formed on the undercoat layer by using the carbon nanotube dispersion 1, and an overcoat layer was formed on the carbon nanotube layer by using the procedure of forming the overcoat layer to thereby form a transparent conductor. The surface resistivity and the total light transmittance were then measured.

### (Example 20)

An undercoat layer having a tetrachloroauric acid content of 10% by weight was formed by repeating the procedure of the Example of forming the undercoat layer. A carbon nanotube layer was formed on the undercoat layer by using the carbon nanotube dispersion 2, and an overcoat layer having a tetrachloroauric acid content of 10% by weight was formed on the carbon nanotube layer by using the procedure of forming the overcoat layer to thereby form a transparent conductor. The surface resistivity and the total light transmittance were then measured.

### (Example 21)

An undercoat layer having a tetrachloroauric acid content of 2% by weight was formed by repeating the procedure of the Example of forming the undercoat layer. A carbon nanotube layer was formed on the undercoat layer by using the carbon nanotube dispersion 2, and an overcoat layer having a tetrachloroauric acid content of 0.2% by weight was formed on the carbon nanotube layer by using the procedure of forming the overcoat layer to thereby form a transparent conductor. The surface resistivity and the total light transmittance were then measured.

### (Example 22)

An undercoat layer having a silver bis(trifluoromethanesulfonyl)imide content of 10% by weight was formed by repeating the procedure of the Example of forming the undercoat layer. A carbon nanotube layer was formed on the undercoat layer by using the carbon nanotube dispersion 2, and an overcoat layer having a silver bis(trifluoromethanesulfonyl)imide content of 10% by weight was formed on the carbon nanotube layer by using the procedure of forming the overcoat layer to thereby form a transparent conductor. The surface resistivity and the total light transmittance were then measured.

### (Example 23)

A hydrophilized PET film was was formed by repeating the procedure of the Example of forming the corona-treated substrate. A carbon nanotube layer was formed on the hydrophilized PET by using the carbon nanotube dispersion 2, and an overcoat layer having 10% by weight aqueous solution of tetrachloroauric acid was formed on the carbon nanotube layer by using the procedure of the Example of forming the overcoat layer to thereby form a transparent conductor. The surface resistivity and the total light transmittance were then measured.

### (Comparative Example 5)

A hydrophilized PET film was was formed by repeating the procedure of the Example of forming the corona dischaeged treated substrate. A carbon nanotube layer was formed on the hydrophilized PET by using the carbon nanotube dispersion 2, and an overcoat layer was formed on the carbon nanotube layer by using the procedure of the Example of forming the overcoat layer to thereby form a transparent conductor. The surface resistivity and the total light transmittance were then measured.

### (Example 24)

An undercoat layer having a tetrachloroauric acid content of 10% by weight was formed by repeating the procedure of forming the undercoat layer. A carbon nanotube layer was formed on the undercoat layer by using the carbon nanotube dispersion 2 to thereby form a transparent conductor. The surface resistivity and the total light transmittance were then measured.

**[Table 1]**

| | Type of the carbon nanotube dispersion | Concentration of the carbon nanotube dispersion (% by weight) | Bar coater number | Coating weight of the carbon nanotubes (mg/m²) | Type of the hole doping compound | Content of the hole doping compound in the undercoat layer (% by weight) | Content of the hole doping compound in the overcoat layer (% by weight) | Surface resistivity (Ω/□) | Total light transmitttance (%) |
|---|---|---|---|---|---|---|---|---|---|
| Example 1 | 1 | 0.055 | #5 | 4.1 | HAuCl₄ | 20 | 0 | 210 | 87.7 |
| Example 2 | | | | | | 10 | 0 | 206 | 87.9 |
| Example 3 | | | | | | 2 | 0 | 253 | 87.7 |
| Comparative Example 1 | | | | | None | 0 | 0 | 299 | 87.9 |
| Example 4 | 2 | 0.040 | #5 | 3.0 | HAuCl₄ | 20 | 0 | 413 | 89.5 |
| Example 5 | | | | | | 10 | 0 | 465 | 89.5 |
| Example 6 | | | | | | 2 | 0 | 490 | 89.6 |
| Example 7 | | | | | | 1 | 0 | 625 | 89.6 |
| Example 8 | | | | | | 0.2 | 0 | 597 | 89.6 |
| Comparative Example 2 | | | | | None | 0 | 0 | 720 | 89.6 |
| Example 9 | | | | | FeCl₃ | 10 | 0 | 586 | 89.0 |
| Example 10 | 1 | 0.055 | #4 | 3.3 | HAuCl₄ | 0 | 10 | 429 | 90.0 |
| Example 11 | | | | | | 0 | 1 | 413 | 89.9 |
| Example 12 | | | | | | 0 | 0.2 | 464 | 89.8 |
| Comparative Example 3 | | | | | None | 0 | 0 | 626 | 89.9 |
| Example 13 | 2 | 0.040 | #5 | 3.0 | HAuCl₄ | 0 | 20 | 400 | 88.6 |
| Example 14 | | | | | | 0 | 10 | 382 | 89.3 |
| Example 15 | | | | | | 0 | 2 | 419 | 88.9 |
| Example 16 | | | | | | 0 | 1 | 489 | 89.2 |
| Example 17 | | | | | | 0 | 0.2 | 625 | 89.6 |
| Example 18 | | | | | Ag-TFSI | 0 | 10 | 564 | 89.2 |
| Example 19 | 1 | 0.055 | #5 | 4.1 | HAuCl₄ | 10 | 1 | 211 | 87.6 |
| Comparative Example 4 | | | | | None | 0 | 0 | 299 | 87.9 |
| Example 20 | 2 | 0.040 | #5 | 3.0 | HAuCl₄ | 10 | 10 | 365 | 89.4 |
| Example 21 | | | | | | 2 | 0.2 | 504 | 89.4 |
| Example 22 | | | | | Ag-TFSI | 10 | 10 | 591 | 89.0 |
| Example 23 | | | | 3.0 | HAuCl₄ | *1 | 10 | 586 | 88.9 |
| Comparative Example 5 | | | | | None | *1 | 0 | 1103 | 88.9 |
| Example 24 | | | | | HAuCl₄ | 10 | *2 | 393 | 88.1 |

| | | | | | | | | | |
|---|---|---|---|---|---|---|---|---|---|
| *1 no undercoat (corona treatment) *2 no overcoat | | | | | | | | | |

Type of the carbon nanotube dispersion, concentration of the carbon nanotube dispersion, bar coater number used for spreading the carbon nanotubes, coating weight of the carbon nanotubes, type of the hole doping compound, content of the hole doping compound in the undercoat layer, content of the hole doping compound in the overcoat layer, surface resistivity, and total light transmittance of the Examples 1 to 24 and Comparative Examples 1 to 5 are shown in Table 1.

In Table 1, when the coating was conducted by using the carbon nanotube dispersion of the same concentration and the coating bar of the same count for the carbon nanotube coating, the coating weight of the carbon nanotubes is considered to be the same in all cases, and difference in the total light transmittance of the sample is also considered to be within the allowable range. However, when the tetrachloroauric acid content in the undercoat layer is 0.2 to 20% by weight (Examples 1 to 3 and 4 to 8), the surface resistivity is about 13 to 43% lower than the cases not containing the tetrachloroauric acid (Comparative Examples 1 and 2). When the iron chloride content in the undercoat layer is 10% by weight (Example 9), the surface resistivity is about 19% lower than the cases not containing the iron chloride (Comparative Example 2). When the amount of the tetrachloroauric acid added to the overcoat layer is 0.2 to 20% by weight (Examples 10 to 12 and 13 to 17), the surface resistivity is about 13 to 47% lower than the cases with no incorporation treatment (Comparative Examples 2 and 3). When the content of the silver bis(trifluoromethanesulfonyl)imide in the overcoat layer is 10% by weight (Example 18), the surface resistivity is about 22% lower than the cases not containing the silver bis(trifluoromethanesulfonyl)imide (Comparative Example 2). When the content of the tetrachloroauric acid in the undercoat layer is 2 to 10% by weight, and the content of the tetrachloroauric acid in the overcoat layer is 0.2 to 10% by weight (Examples 19 to 21), the surface resistivity is about 29 to 49% lower than the cases not containing the tetrachloroauric acid (Comparative Example 2 and 4). When the content of the silver bis(trifluoromethanesulfonyl)imide in the undercoat layer is 10% by weight and the content of the silver bis(trifluoromethanesulfonyl)imide is 10% by weight (Example 22), the surface resistivity is about 18% lower than the case not containing the silver bis(trifluoromethanesulfonyl)imide (Comparative Example 2). When the undercoat layer is not provided and the content of the tetrachloroauric acid in the overcoat layer is 10% by weight (Example 23), the surface resistivity is about 47% lower than the case not containing the tetrachloroauric acid (Comparative Example 4). When the overcoat layer is not provided and the amount of the tetrachloroauric acid incorporated in the undercoat layer is 10% by weight (Example 24), the surface resistivity is about 45% lower than the case not containing the tetrachloroauric acid (Comparative Example 2).

**[Table 2]**

| | Content of tetrachloroauric acid in the undercoat layer (% by weight) | Water contact angle (°) |
|---|---|---|
| Example 1 | 20 | 18.86 |
| Example 2 | 10 | 10.84 |
| Example 3 | 2 | 5.88 |
| Comparative Example 1 | - | 4.84 |

The water contact angle of the undercoat layer in Examples 1 to 3 and Comparative Example 1 is shown in Table 2.

As demonstrated in Table 2, the water contact angle of the undercoat layer having 2 to 20% by weight of tetrachloroauric acid incorporated therein was 5.88 to 18.86°, and the contact angle increased with the increase in the content of the tetrachloroauric acid.

### [Industrial Applicability]

The transparent conductor of the present invention can be used for various types of electrically conductive materials.

## Claims

1. A method for producing a transparent conductor wherein an electrically conductive laminate structure is formed on at least one surface of a transparent substrate by spreading a dispersion containing carbon nanotubes over the transparent substrate and drying the dispersion to form an electrically conductive layer, wherein the method includes:
the step of forming an undercoat layer containing a hole doping compound at a proportion of 0.2 to 20% by weight on a transparent substrate before forming an electrically conductive layer, and/or
the step of forming an overcoat layer containing a hole doping compound at a proportion of 0.2 to 20% by weight after forming an electrically conductive layer.

2. A method for producing a transparent conductor comprising the steps of
forming an undercoat layer on a transparent substrate,
spreading a dispersion containing carbon nanotubes and drying the coated layer to form an electrically conductive layer, and
forming an overcoat layer,
conducted in this order to form an electrically conductive laminate structure on at least one surface of a transparent substrate, wherein a hole doping compound is incorporated at a proportion of 0.2 to 20% by weight in the undercoat layer and/or the overcoat layer.

3. A method for producing a transparent conductor according to claim 2 wherein the water contact angle of the undercoat layer is 5 to 20°.

4. A method for producing a transparent conductor according to any one of claims 1 to 3 wherein the hole doping compound is a metal halide.

5. A method for producing a transparent conductor according to claim 4 wherein the metal halide contains tetrachloroauric acid.

6. A transparent conductor having an undercoat layer containing a hole doping compound at a proportion of 0.2 to 20% by weight and an electrically conductive layer containing carbon nanotubes disposed in this order on at least one surface of a transparent substrate.

7. A transparent conductor having an electrically conductive layer containing carbon nanotubes and an overcoat layer containing a hole doping compound at a proportion of 0.2 to 20% by weight disposed in this order on at least one surface of the transparent substrate.

8. A transparent conductor having an undercoat layer containing a hole doping compound at a proportion of 0.2 to 20% by weight, an electrically conductive layer containing carbon nanotubes, and an overcoat layer containing a hole doping compound at a proportion of 0.2 to 20% by weight disposed in this order on at least one surface of a transparent substrate.

9. A transparent conductor according to any one of claims 6 to 8 wherein the hole doping compound is a metal halide.

10. A transparent conductor according to claim 9 wherein the metal halide contains tetrachloroauric acid.
